Europäisches Patentamt

European Patent Office

Office européen des brevets

(19)

(11) Numéro de publication: **0 090 699**
**B1**

(12) **FASCICULE DE BREVET EUROPEEN**

(45) Date de publication du fascicule du brevet:
06.11.85

(51) Int. Cl.⁴: **G 01 R 31/36**

(21) Numéro de dépôt: 83400527.4

(22) Date de dépôt: 15.03.83

(54) Procédé et dispositif de mesure de l'état de charge d'un générateur électrochimique en fonctionnement.

(30) Priorité: 17.03.82 FR 8204493

(43) Date de publication de la demande:
05.10.83 Bulletin 83/40

(45) Mention de la délivrance du brevet:
06.11.85 Bulletin 85/45

(84) Etats contractants désignés:
AT BE DE FR GB IT NL SE

(56) Documents cités:
EP - A - 0 003 917
DE - B - 2 842 817
FR - A - 2 370 982
US - A - 4 289 836

(73) Titulaire: **REGIE NATIONALE DES USINES RENAULT,
Boîte postale 103 8-10 avenue Emile Zola,
F-92109 Boulogne-Billancourt (FR)**
Titulaire: **Lefebvre, Jean-Paul, 10, rue du Fief,
F-77930 Cely-en-Biere (FR)**

(72) Inventeur: **Lefebvre, Jean-Paul, 10, rue de Fief,
F-77930 Cely-En-Biere (FR)**
Inventeur: **Pedron, Thierry, Chemin des Peupliers,
F-38240 Meylan (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

## Description

L'invention concerne un procédé et un dispositif de mesure de l'état de charge d'un générateur électrochimique pendant la charge ou la décharge de ce dernier. L'invention s'applique principalement aux générateurs au plomb, mais elle peut l'être également aux générateurs au nickel ou autres.

De tels dispositifs sont connus qui reposent sur plusieurs principes différents:

— les dispositifs A/h métriques sont des appareils intégrateurs de l'intensité du générateur et permettent de compter les A/h débités pendant une utilisation active;

— les dispositifs voltmétriques, par référence à une courbe de décharge, utilisent directement la tension du générateur pour décrire l'état de charge de celui-ci.

Des dispositifs voltmétriques déduisent la force électromotrice à vide de la mesure de la tension t du courant débité par le générateur par l'intermédiaire de la connaissance à priori de la résistance interne de celui-ci et la loi d'Ohm.

Ces dispositifs de l'art antérieur présentent de nombreux inconvénients tels que:

— la mauvaise connaissance de la capacité initiale de la batterie, la méconnaissance du rendement exact lors de la recharge, la non-prise en compte de l'autodécharge;

— un fonctionnement non continu et la non-prise en compte des faibles décharges;

— la présence de shunts à calculer suivant les applications ainsi que l'ignorance de la variation de la résistance interne du générateur en cours de fonctionnement;

— dans la plupart des applications jusqu'à présent réalisées, l'absence de fonctionnement lors de la recharge du générateur.

On connaît par ailleurs, par la demande de brevet français FR N° 2437727, un procédé et un appareil de détermination de la capacité d'une batterie suivant lesquels on mesure la tension à vide $V_M$ de la batterie lors de son branchement initial, qui représente sa force électromotrice E (to) à l'instant to dudit branchement initial, on mesure ensuite la tension en charge ou en décharge Vb de la batterie à un instant $t_1$, on calcule la différence $\Delta V = E$ (to) $-$ Vb, et on calcule la valeur de la force électromotrice E ($t_1$) de la batterie représentative de son état de charge à l'instant $t_1$ en fonction de la différence $\Delta V$ et de sa force électromotrice à l'instant to.

Malheureusement, cette demande de brevet présente une lacune fondamentale qui le rend inexploitable pour un spécialiste de la technique dans la mesure où elle n'indique pas comment la force électromotrice en charge ou en décharge, à l'instant $t_1$, est calculée en fonction de $\Delta V$ et de la force électromotrice E(to) à l'instant du branchement initial to.

Il est en effet connu que la tension aux bornes d'une batterie en charge ou en décharge dépend à la fois de son état de charge et de sa vitesse ou taux de charge ou décharge. Cela ressort du réseau de courbes de la fig. 1A qui illustre la relation entre la tension V de chaque élément d'une batterie d'accumulateurs au plomb exprimée en volts et sa durée de décharge d exprimée en heures. Sur ce réseau, la courbe $C_1$ représente un état de charge de la batterie égal à 50% de sa capacité, la courbe $C_2$ un état de charge égal à 25% de sa capacité et la courbe $C_3$ la tension finale de l'élément pour diverses durées ou taux de décharge. C'est ainsi, par exemple, qu'une tension de 1,90 V mesurée sur un élément correspondra à une capacité résiduelle de 50%, avec un taux de décharge de 2 h, et à une capacité résiduelle de 25% environ avec un taux de décharge de 8 h.

Il ressort de ce qui précède qu'il n'est pas possible, dans l'état actuel des connaissances sur le fonctionnement des générateurs électrochimiques, de déduire la capacité résiduelle d'une batterie en charge ou en décharge de la seule connaissance de la tension à ses bornes. En effet, il faut en outre connaître son taux de décharge. Or, ce paramètre est particulièrement difficile à mesurer puisque les batteries sont généralement soumises à un fonctionnement discontinu, notamment à bord des véhicules automobiles où le courant débité peut varier dans des proportions importantes sur de courtes périodes.

L'invention vise à fournir, à partir d'une connaissance particulière du fonctionnement des générateurs électrochimiques, un procédé et un dispositif qui assurent la détermination de l'état de charge de ce générateur, que celui-ci soit en charge ou en décharge, tout en s'affranchissant de la mesure ou du calcul de son taux de décharge.

A cet effet, l'invention a pour objet un procédé de mesure de l'état de charge d'un générateur électrochimique pendant la charge ou la décharge de celui-ci, suivant lequel on mesure la tension à vide $V_M$ du générateur lors de son branchement initial, qui représente sa force électromotrice E (to) à l'instant to dudit branchement initial, on mesure ensuite la tension en charge ou en décharge Vb du générateur à un instant $t_1$, on calcule la différence $\Delta V = E$ (to) $-$ Vb, et on calcule la valeur de la force électromotrice E ($t_1$) du générateur représentative de son état de charge à l'instant $t_1$ en fonction de la différence $\Delta V$ et de sa force électromotrice E (to) à l'instant to, caractérisé en ce qu'on calcule E ($t_1$) conformément à la relation E ($t_1$) = E (to) $-$ f ($\Delta V$) $\cdot \tau$ dans laquelle f ($\Delta V$) est une loi prédéterminée qui, pour un type de générateur donné, est indépendante de la capacité nominale de celui-ci et dépend du nombre d'éléments qui le composent et du signe de la différence $\Delta V$ qui est positif à la décharge èt négatif à la charge, et $\tau$ est le temps écoulé entre les instants to et $t_1$.

Suivant une caractéristique de l'invention, ladite loi prédéterminée est de la forme

$$\frac{I}{I_o} = f\ (\Delta V),$$

dans laquelle:

— I est le courant sous lequel le générateur est déchargé ou chargé;

$$-\ I_o = \frac{Q_o}{3600}$$

— Qo est la charge nominale de la batterie définie pour une durée de décharge donnée.

En variante, ladite loi prédéterminée est de la forme

$$\frac{I}{In}=f\ (\Delta V),$$

dans laquelle:

— I est le courant sous lequel le générateur est déchargé ou chargé;

$$-\ In=\frac{Qn}{3600}$$

— Qn est la capacité disponible de la batterie à un régime de charge ou de décharge déterminé.

Suivant une autre caractéristique, on mesure périodiquement la tension Vb du générateur en charge ou décharge et on calcule après chaque mesure sa force électromagnétique représentative de son état de charge conformément à la loi E (t+τ)=E (t)−f (ΔV)τ dans laquelle E (t+τ) représente la force électromotrice à l'instant t+τ, E (t) représente la force électromotrice à l'instant t calculée précédemment, τ représente le temps écoulé entre deux mesures successives et ΔV=E (t)−Vb où Vb est la tension mesurée à l'instant t+τ.

Suivant une autre caractéristique de l'invention, on mesure la température T de l'électrolyte du générateur et on détermine la valeur f (ΔV) en fonction de la variable ΔV et du paramètre constitué par la température T de l'électrolyte.

L'invention a également pour objet un dispositif pour la mise en œuvre du procédé défini ci-dessus comprenant des moyens de mesure de la tension (Vb) du générateur, des moyens pour mémoriser la tension à vide (V=E (to)) du générateur lors de son branchement initial puis la dernière valeur de la force électromotrice calculée (V, $V_M$), des moyens pour calculer la valeur de la différence ΔV entre la tension mesurée (Vb) du générateur et la dernière valeur de la force électromotrice calculée (V, $V_M$), des moyens pour déterminer le signe de ladite différence ΔV, des moyens pour mesurer le temps écoulé (τ) entre deux mesures successives de la tension du générateur, des moyens pour calculer la variation de force électromotrice ΔE=f (ΔV)·τ du générateur, des moyens pour calculer la valeur de la force électromotrice à partir de la dernière valeur calculée (V, $V_M$) et de ladite variation ΔE, et des moyens d'affichage de ladite valeur calculée de la force électromotrice.

Suivant une forme de réalisation du dispositif, lesdits moyens de mémorisation comprennent un compteur-décompteur, et lesdits moyens pour calculer la variation de la force électromotrice comprennent un calculateur pour comparer ladite différence ΔV avec des valeurs ΔVi mises en mémoire, un oscillateur local qui produit l'une ou l'autre de deux fréquences prédéterminées suivant le signe de ladite différence, un générateur de fréquence qui produit une fréquence fonction de celle de l'oscillateur local et de la valeur de ladite différence ΔV, et des moyens pour appliquer sélectivement au compteur-décompteur le signal de sortie du générateur de fréquence en fonction du signe de la différence ΔV.

Suivant une autre forme de réalisation du dispositif, celui-ci comprend des moyens de mesure de la température T de l'électrolyte du générateur, la variation de la force électromotrice étant calculée par lesdits moyens de calcul à partir de la valeur mesurée de la température T et de la valeur et du signe de ladite différence ΔV.

D'autres caractéristiques et avantages de l'invention ressortiront de la description qui va suivre de deux variantes de sa réalisation données uniquement à titre d'exemples et illustrées par les dessins annexés sur lesquels:

— la fig. 1A est un réseau de courbes illustrant, pour une température donnée, la relation entre la tension d'un élément d'accumulateur au plomb (en volts) et le taux de décharge de cet élément (en heures);

— la fig. 1B est un graphique illustrant la relation entre la force électromotrice E d'un élément d'accumulateur au plomb et sa charge Q;

— la fig. 1C est un graphique montrant les courbes

$$\frac{I}{Io}\ et\ \frac{I}{In}$$

établies en fonction de V=E−Vb pour une batterie de 12 V à une température de 20°C;

— la fig. 2 est un schéma synoptique illustrant la structure générale du dispositif suivant l'invention;

— la fig. 3 est un schéma électrique général illustrant une forme de réalisation du dispositif de mesure suivant l'invention dans lequel la température de l'électrolyte n'est pas prise en compte;

— les fig. 4 à 12 sont des schémas de détail de certains des circuits du dispositif de la fig. 3;

— les fig. 13 et 14 forment ensemble un algorithme illustrant le fonctionnement du procédé suivant l'invention dans le cas où il est mis en œuvre avec un calculateur microprogrammé, suivant une seconde forme de réalisation du dispositif suivant l'invention.

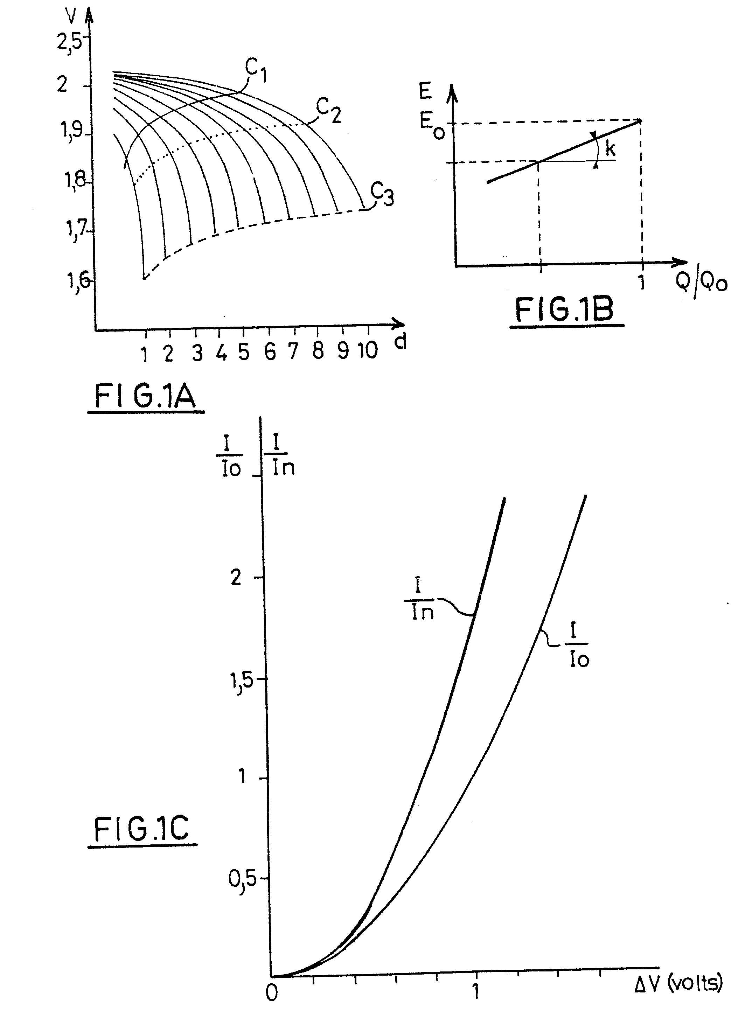

Des résultats classiques montrent que la densité d'électrolyte est un bon indicateur d'état de charge des générateurs électrochimiques. D'autre part, une loi sensiblement linéaire lie cette densité d'électrolyte à la force électromotrice à vide du générateur. Par conséquent, il existe une loi également à peu près linéaire entre la force électromotrice à vide du générateur et sa quantité de charge, au moins dans une certaine gamme d'états de charge. Cette relation linéaire est illustrée à la fig. 1B où la force électromotrice E est exprimée en fonction de la quantité de charge Q ramenée à la charge nominale Qo de la batterie. La pente de cette droite étant k, on peut examiner la relation entre E et Q sous la forme;

$$E=Eo+k\cdot\left(\frac{Q-1}{Qo}\right) \qquad (1)$$

expression dans laquelle:

— Qo est la charge nominale de la batterie définie pour une durée de décharge donnée, par exemple 20 h;

— Eo est la force électromotrice correspondant à la charge Qo.

Sachant par ailleurs que l'on a, à tout instant,

$$Q = Qo - \int I\, dt,$$

l'expression (1) devient:

$$E = Eo - k\int \frac{I}{Qo}\, dt \qquad (2)$$

Partant de ces résultats classiques, on peut écrire: $Qo = Io \times 3600$. En remplaçant Qo dans (2), on obtient:

$$E = Eo - \frac{k}{3600}\int \frac{I}{Io} \cdot dt \qquad (3)$$

L'invention est basée sur l'observation, originale par rapport aux connaissances antérieures en matière de générateurs électrochimiques, qu'il existe une relation entre le terme

$$\frac{I}{Io}$$

et la différence $E - Vb = \Delta V$, E étant la force électromotrice du générateur et Vb la tension à ses bornes quand il débite ou reçoit un certain courant I. On a donc

$$\frac{I}{Io} = f(E - Vb) = f(\Delta V) \qquad (4)$$

Cette relation est remarquable en ce sens que pour un type de générateur donné elle ne dépend que du nombre d'éléments du générateur et de la température et est indépendante de la charge nominale du générateur.

La fig. 1C illustre cette relation pour un générateur électrochimique au plomb de 12 V fonctionnant à la décharge sous une température de 20°C. Des courbes similaires (non représentées) lient également

$$\frac{I}{Io} \text{ et } \Delta V = E - Vb$$

dans une certaine gamme de fonctionnements en charge.

Partant des relations (3) et (4) et en considérant le coefficient

$$\frac{k}{3600}$$

compris dans la loi $f$ qui lie

$$\frac{I}{Io}$$

à $\Delta V$, on peut écrire, pour de faibles variations de temps $\tau$:

$$E(t+\tau) = E(t) - f(\Delta V) \cdot \tau \qquad (5)$$

formule dans laquelle:

— $\tau$ représente la période de scrutation ou d'échantillonnage de la tension Vb de la batterie en charge ou en décharge,

— $E(t+\tau)$ représente la f.e.m à l'instant $t+\tau$;

— $E(t)$ représente la f.e.m à l'instant t;

— $\Delta V = E - Vb$, E étant la f.e.m du générateur et Vb sa tension quand il débite ou reçoit un certain courant I.

Il est donc possible, partant de la seule connaissance de la force électromotrice du générateur à l'instant to et de la tension Vb à ses bornes à l'instant to$+\tau$, d'en déduire sa force électromotrice $E(to+\tau)$, et par conséquent son état de charge, à l'instant to$+\tau$. En répétant le processus, par scrutation de la tension Vb du générateur avec une périodicité $\tau$, on peut donc connaître en permanence l'état de charge du générateur, avec une erreur d'autant plus faible que $\tau$ sera également plus faible.

Comme on l'a indiqué précédemment, la relation

$$\frac{I}{Io} = f(\Delta V)$$

est fonction de la température T de l'électrolyte.

Sur la fig. 1C, la courbe correspondante a été tracée pour une température de 20°C, mais il est évident que l'on peut établir une famille de courbes correspondant chacune à une température donnée. En mesurant la température T, on pourra ainsi tenir compte de celle-ci dans le calcul de $E(t+\tau)$.

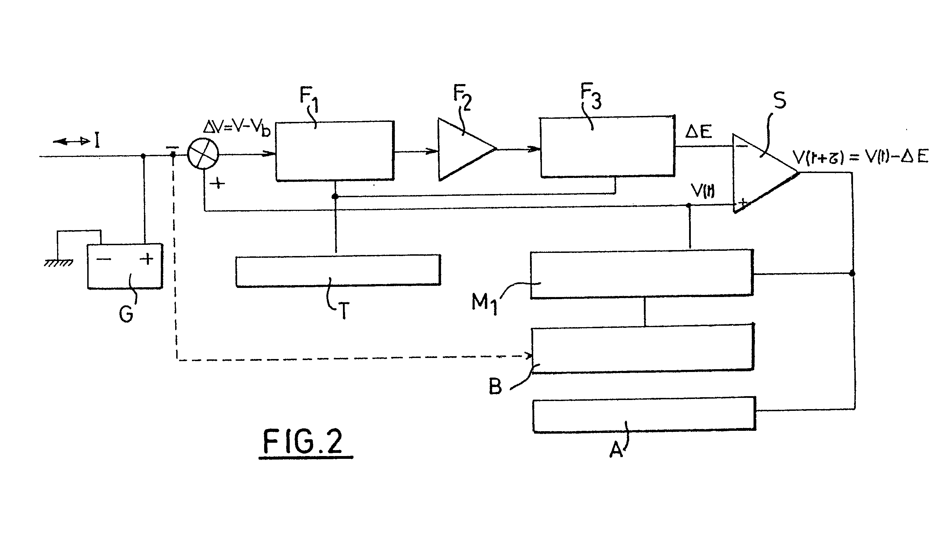

En se reportant à la fig. 2, qui est un schéma synoptique du dispositif permettant la mise en œuvre du processus décrit ci-dessus, on remarque que le système est bouclé et que le contenu $V(t)$ d'une mémoire $M_1$, dans laquelle est stockée la valeur de la force électromotrice calculée, vient se soustraire de la valeur de la tension Vb du générateur G. L'utilisation d'une certaine fonction de transfert $F_1$ représentative de la courbe de la fig. 1C permet de déduire l'image du courant I que débite la batterie; son intégration en $F_2$ et l'utilisation d'une deuxième fonction de transfert $F_3$ permettent de calculer la chute de force électromotrice $\Delta E$, subséquente au courant débité pendant une certaine durée $\tau$, durée d'une boucle de calcul augmentée d'une certaine temporisation; puis, la soustraction en S de $\Delta E$ de la valeur de la force électromotrice calculée $V(t)$ à l'instant t permet de déduire la nouvelle valeur de la force électromotrice $V(t+\tau)$ à l'instant t$+\tau$, valeur qui est substituée à $V(t)$ dans la mémoire $M_1$ et affichée sur un dispositif d'affichage A.

Le schéma est complété par une boucle B de mesure de la tension à vide du générateur à l'instant initial de sa mise en fonctionnement en charge ou décharge, et éventuellement par un bloc T de mesure de la température qui peut être prise en compte au niveau des fonctions de transfert $F_1$ et $F_2$.

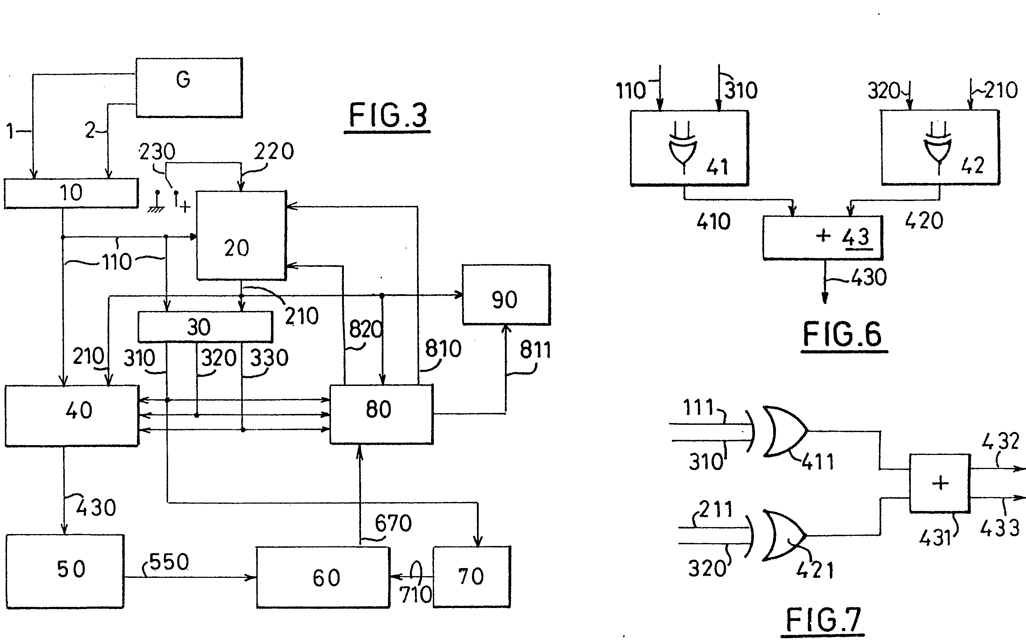

En se reportant à la fig. 3, l'information tension Vb du générateur G est appliquée à un système convertisseur analogique-numérique 10 par l'intermédiaire de conducteurs 1 et 2.

Ce convertisseur échantillonne la tension du générateur G à une fréquence de 41 kHz. La sortie du convertisseur 10 est connectée à un compteur-décompteur binaire synchrone 20, ainsi qu'à un système 40 de calcul de la valeur absolue de la différence tension batterie — force électromotrice calculée, par l'intermédiaire d'un bus de donnée 8 bits 110.

Du compteur-décompteur synchrone 20 sort un bus 210. Ce bus véhicule la valeur de la force électromotrice calculée $V=E(t)$. Ce bus 210 entre sur un comparateur 30. Les informations contenues dans ce bus sont comparées à celles du bus 110, transmettant l'information tension batterie en numérique. De ce comparateur 30 sortent trois informations binaires décrivant la valeur relative des deux informations d'entrée 110 et 210. Ces informations binaires sont véhiculées par les conducteurs 310, 320 et 330.

Ces informations 310, 320 et 330 sont utilisées par le calculateur 40. Celui-ci, qui reçoit aussi les informations tension batterie Vb (bus 110) et valeur de la force électromotrice calculée V (bus 210), calcule la valeur absolue de la différence tension batterie moins force électromotrice: $\Delta V$. Cette différence est comparée à un ensemble de valeurs $\Delta Vi$ mises en mémoire dans des comparateurs d'un calculateur 50. Il sort de celui-ci un bus 550 commandant des interrupteurs analogiques contenus dans un bloc 60. Ce bloc 60 sort une fréquence sur le conducteur 670. Cette fréquence est fonction de $\Delta V$ par l'intermédiaire du bus 550 et de la fréquence générée par un oscillateur local 70. Celui-ci est lui-même commandé par l'information 310 provenant du comparateur 30. Ainsi, la fréquence de base fo sortant de l'oscillateur 70 est commandée par le comportement de la batterie: charge ou décharge.

Le conducteur 670 est connecté à un système 80. Celui-ci sélectionne la valeur de ses sorties 810 et 820 en fonction des informations provenant du comparateur 30: conducteurs 310, 320 et 330.

Les sorties 810 et 820 entrent sur les entrées «up» et «down» du compteur-décompteur synchrone 20.

Du système 80 sort également un conducteur 811 connecté à un système 90 d'affichage de l'information reçue par l'intermédiaire du bus 210, c'est-à-dire la force électromotrice calculée V.

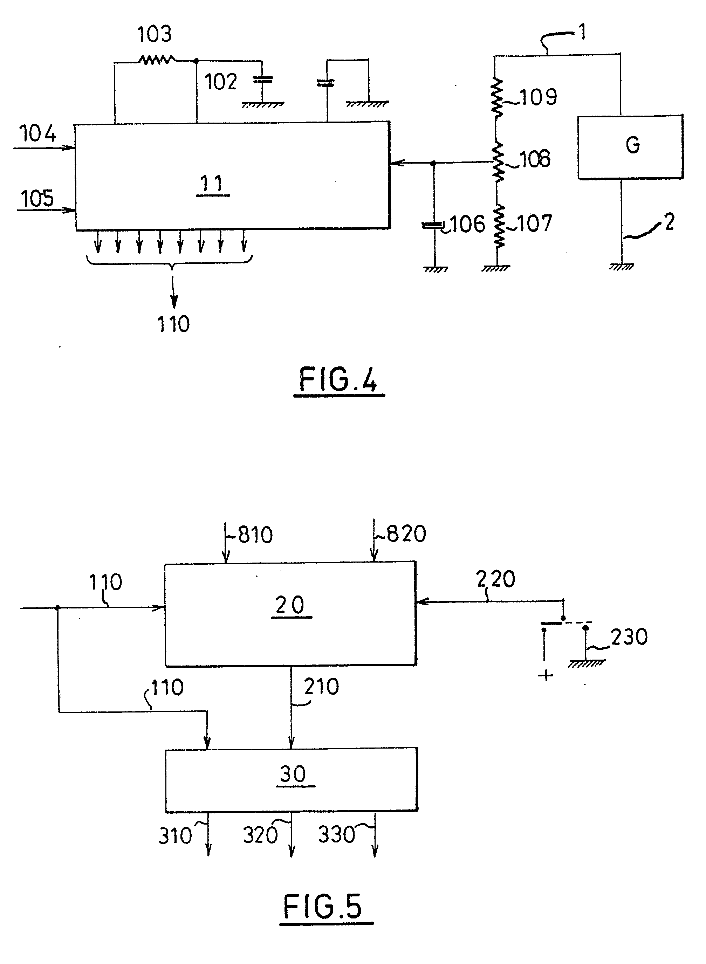

Le fonctionnement du dispositif de la fig. 3 sera maintenant décrit en se reportant également aux fig. 4 à 12.

En fonctionnement, le signal électrique provenant du générateur G par l'intermédiaire du conducteur 1 entre sur un pont diviseur 107, 108 et 109, divisant la tension par un nombre fonction du nombre d'éléments (fig. 4). Ensuite, ce signal entre sur l'entrée d'un convertisseur analogique-numérique 11, après avoir été filtré par un condensateur 106. Ce convertisseur analogique-numérique 11 possède une horloge interne dont la fréquence est déterminée par une résistance 103 (10 k $\Omega$) et un condensateur 102 (2,2 nF). Les branches de la résistance 103 entrent sur les entrées CLK R et CLK IN du convertisseur. La fréquence de celui-ci est ainsi fixée à 41 kHz. Le convertisseur est alimenté par des conducteurs 104 et 105 en 5V. Du convertisseur 11 sort un bus de données 110. Ce bus 110 véhicule l'information tension générateur, notée Vb, dans le reste du dispositif.

La fig. 5 montre que le compteur-décompteur 20 a pour rôle de traiter les informations provenant du bus 110. A un instant initial, le système convertisseur 10 saisit l'information tension générateur à vide et transmet cette information au compteur-décompteur 20. A cet instant initial, un inverseur 230 est mis à 0: un conducteur 220 met donc également l'entrée LOAD du compteur 20 à 0, ce qui permet la mémorisation de la force électromotrice initiale du générateur. L'inverseur 230 est ensuite mis à l'état 1. En cours de fonctionnement, la tension aux bornes du générateur G varie quand celui-ci est sollicité par un courant I le traversant (charge ou décharge). Le système formé par les éléments 30, 40, 50, 60 et 80 calcule la vitesse de croissance ou de décroissance de la force électromotrice mise initialement en mémoire dans le compteur-décompteur 20. Le résultat de ce calcul est transmis aux entrées «down» et «up» du compteur-décompteur 20 respectivement par les conducteurs 810 et 820. De ce compteur-décompteur 20 sort le bus 210 représentatif de la force électromotrice du générateur, notée V, à l'instant considéré. Les bus 110 et 210 entrent sur le comparateur 8 bits 30, formé de deux comparateurs 4 bits MC74C193 placés en cascade. De ce comparateur 30 sortent les trois conducteurs 310, 320 et 330:

— Si $Vb<V$, les sorties 310, 320 et 330 sont respectivement à l'état 1, 0, 0.

— Si $Vb>V$, les sorties 310, 320 et 330 sont respectivement à l'état 0, 1, 0.

— Si $Vb=V$, les sorties 310, 320 et 330 sont respectivement à l'état 0, 0, 1.

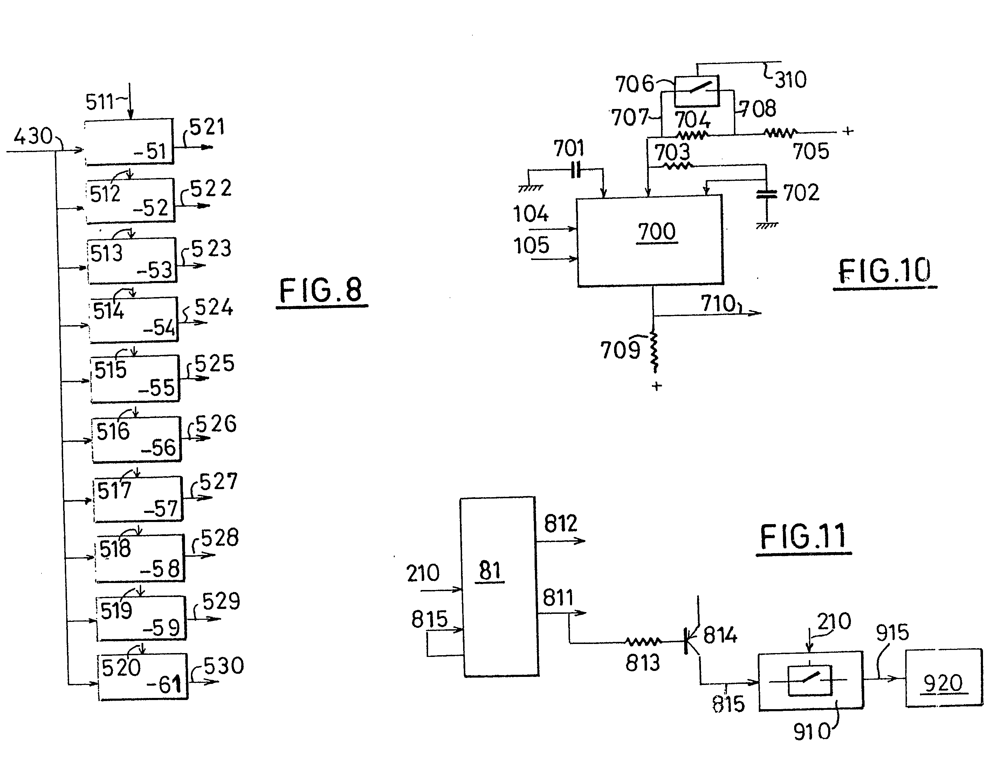

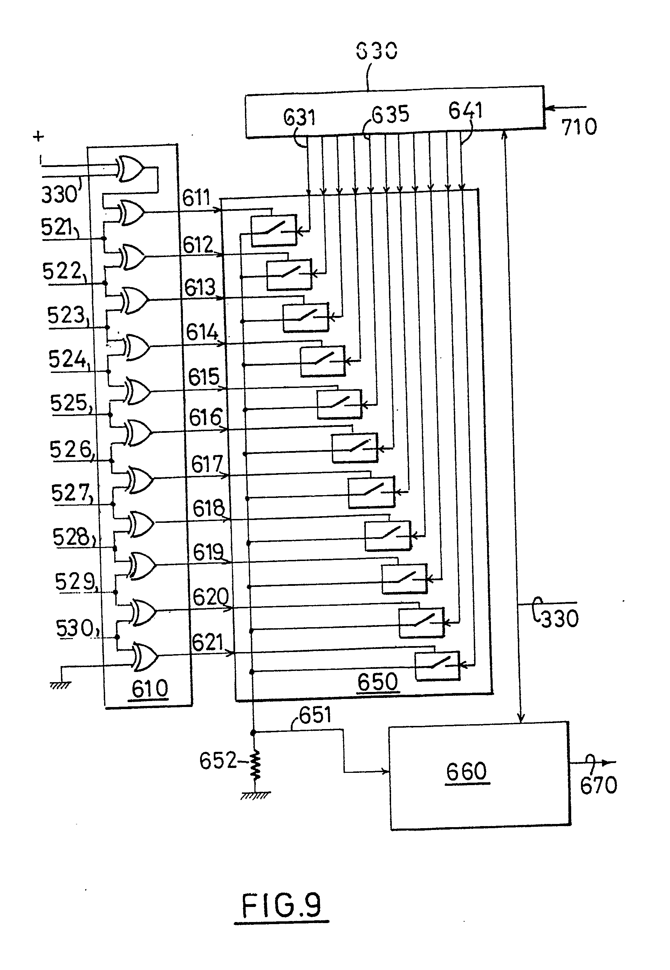

La fig. 6 est un développement du système 40 décrit dans le schéma électrique de la fig. 3. Ce système calcule la valeur absolue de la différence $V-Vb$ en procédant de la manière suivante:

— Si $Vb<V$, le conducteur 310 est à l'état 1 et le conducteur 320 à l'état 0.

Du bloc 41, qui est un ensemble de huit portes «ou exclusif» du type CD 4 030, sort un signal $\overline{V}b$, complémentaire de Vb. Celui-ci est véhiculé par un bus 410.

Du bloc 42, qui est aussi un ensemble de huit portes «ou exclusif» du type CD 4 030, sort le signal V, véhiculé par un bus 420.

Ces bus 410 et 420 entrent sur un sommateur 43 qui sort la valeur $V+\overline{V}b$ ou encore $V-Vb$. Ce sommateur 43 est réalisé à l'aide de deux sommateurs CD 4 008 en cascade.

— Si $Vb>V$, le conducteur 310 est à l'état 0 et le conducteur 320 à l'état 1. Pour le reste, le processus est identique à celui décrit ci-dessus. Le sommateur 43 sort la valeur $Vb+\overline{V}$ ou $Vb-V$.

Par conséquent, le bus 430 de sortie du sommateur 43 véhicule bien l'information $\Delta V=|V-Vb|$.

La fig. 7 décrit le calcul au niveau d'un bit. Les conducteurs 111 et 211 véhiculent les bits de même poids de Vb et V. Les sorties des deux portes «ou exclusif» 411, 421 entrent sur un sommateur par bit 431 qui donne la valeur du bit somme du même poids 432, ainsi que la retenue en 433.

Le bus 430 entre sur dix comparateurs 51 à 59 et 61 (2 fois dix MMC 7 485), ainsi que le montre la fig. 8. Les informations contenues dans le bus 430 sont comparées à 10 valeurs (bus de données 511 à 520) représentatives des données $\Delta V_i$ de la courbe choisie de la fig. 1C. Ces données $\Delta V_i$ sont dans une progression définie par l'allure de cette courbe. De ces comparateurs sort sur des conducteurs 521 à 530 l'information 1 si: $\Delta V = |V - Vb| > \Delta V_i$, et 0 si $\Delta V < \Delta V_i$.

La fig. 9 montre l'utilisation des dix conducteurs 521 à 530. Ils entrent deux à deux sur dix portes «ou exclusif» d'un bloc 610, de telle sorte que les sorties 611 à 621 de ce bloc 610 soient toutes à zéro sauf l'une d'elles qui est à l'état 1: ce conducteur sera tel que sur une des entrées de la porte «ou exclusif» en question figurera le niveau 0 et sur l'autre entrée le niveau 1. Si $\Delta V_{i-1} < \Delta V < \Delta V_i$, alors le conducteur 61i sera à l'état 1 et il sera le seul de cette série. Ces conducteurs 611 à 621 actionnent, quand ils sont à l'état 1, des interrupteurs analogiques contenus dans un bloc 650. Chaque entrée de ces interrupteurs est reliée à l'une des sorties $Q^k$ 631 à 641, avec k entier compris entre 2 et 12, d'un boîtier 630. Celui-ci est un compteur binaire à 12 étages, CD 4 040. Il divise par $2^k$, k étant un entier compris entre 2 et 12, le signal provenant de l'oscillateur local défini à la fig. 10.

Du boîtier 650 sort donc un seul signal dont la fréquence fk vaut $fo/2^k$, fo étant la fréquence de l'oscillateur local et k dépendant de l'interrupteur analogique sélectionné par les portes 610. Ce signal est véhiculé par un conducteur 651, 652 étant une résistance de charge des interrupteurs du boîtier 650. Le conducteur 651 entre sur l'entrée «horloge» d'un deuxième compteur binaire 660, CD 4 020. De ce compteur sort le signal 670 dont la fréquence est $2^{14}$ fois plus petite que celle du signal d'entrée. La fréquence de ce signal vaut donc $fo \times 2^{-14-k}$. Les entrées RESET des deux compteurs 630 et 660 sont reliées à la sortie A=B du comparateur 30 par le conducteur 330. Quand V=Vb, cette sortie 330 est à l'état 1 et le signal qui sort du boîtier 660 par le conducteur 670 est à l'état 0. La suite montrera que cet état bloque le comptage du compteur-décompteur 20.

La fig. 10 explicite le fonctionnement de l'oscillateur local utilisé par le compteur 630. Il s'agit d'un circuit 700 de type ICM 7 555 monté en multivibrateur astable. 104 et 105 sont les tensions d'alimentation. La fréquence de l'oscillateur est fixée par des résistances 703 (1 kΩ), 704 (47 kΩ) et 705 (15 kΩ), ainsi que par un condensateur 702 (33 nF). Si le générateur G est en décharge alors Vb<V et le conducteur 310 véhicule un signal 1. Ce conducteur entre sur une commande de porte analogique. Dans cet état, les sorties 707 et 708 de cet interrupteur sont donc reliées et la fréquence d'oscillation $fo_d$ vaut 2,6 kHz. Si le générateur G est en charge, alors le conducteur 310 est à zéro, l'interrupteur analogique 706 est dans un état non passant et la fréquence d'oscillation $fo_c$ vaut 691 Hz. La sortie 710 du circuit 700 est reliée au plus de l'alimentation par une résistance de charge 709 de 10 kΩ. Cette sortie entre également sur le compteur binaire 630, ainsi que nous l'avions déjà décrit au paragraphe précédent.

En se reportant à la fig. 11, le système 80 comprend un circuit 81 formé de deux comparateurs MM 74 C 85. Le conducteur 815 est un bus d'un mot de 8 bits mis en mémoire dans le circuit 81 et qui définit deux butées haute et basse. Associé à la donnée f.é.m calculée V (conducteur 210), le circuit 81 permet de sortir sur des conducteurs 811 et 812 deux informations qui définissent deux butées pour cette force électromotrice calculée V. Soit $E_B$ la butée basse et $E_H$ la butée haute: le circuit 81 réalise les fonctions suivantes:

Si $V < E_B$ 811 est à 1 et 812 à 0
Si $E_B < V < E_H$ 811 est à 0 et 812 à 0
Si $V = E_H$ 811 est à 0 et 812 à 1.

Les données des conducteurs 811 et 210 sont traitées par un dispositif de mise en forme de l'affichage comprenant une résistance 813, un transistor 814 et des portes analogiques 910.

Si $V < E_B$, le transistor 814 est bloqué et le dispositif d'affichage 920 est dans un état bas;

Si $V > E_B$, le transistor 814 est passant et l'information du bus 915 de sortie de l'ensemble de commutateurs analogiques programmables 910, du type CD 4 066, est modulée par la valeur de la force électromotrice V transmise par le conducteur 210.

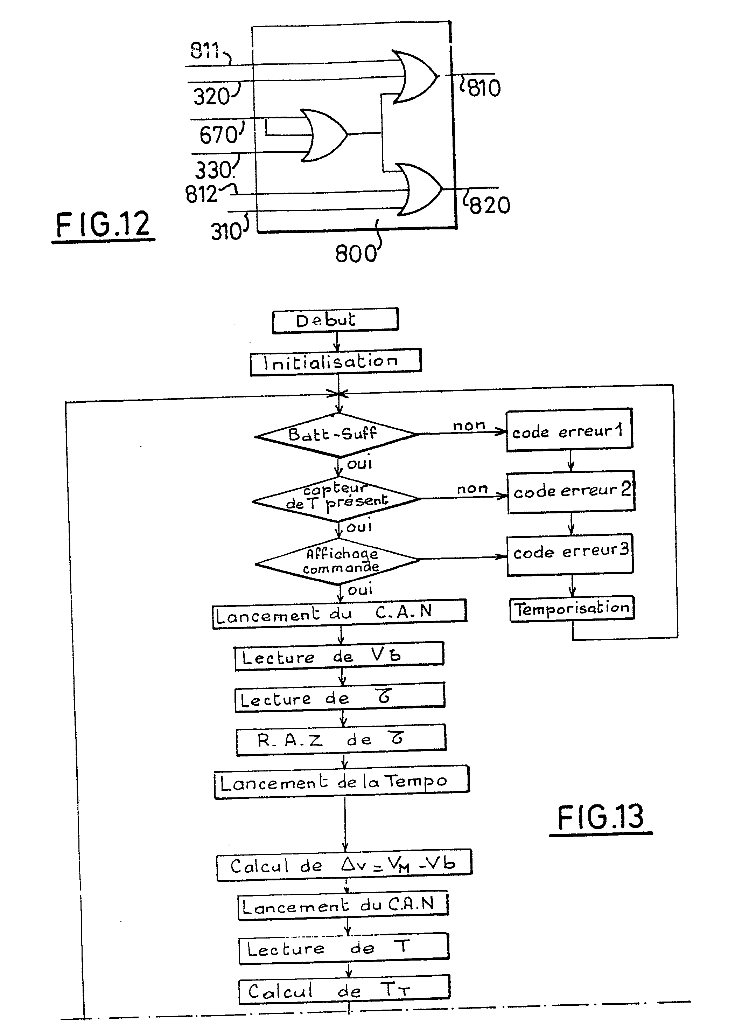

Le dispositif d'affichage 920 peut être réalisé par des diodes électroluminescentes ou par un milliampèremètre. Le reste du système  ⌐ est présenté à la fig. 12: il assure des fonctions logiques combinatoires au moyen d'un circuit de portes 800:

— Cas de la décharge; Vb<V. Alors:

Si $V < E_B$; 811 est à l'état 1, 320 à l'état 0, 330 à l'état 0, 812 à l'état 0, 310 à l'état 1. Par conséquent, la sortie 810 «down» est à l'état 1, ainsi que la sortie «up» 820: le compteur 20 est bloqué.

Si $E_B < V < E_H$; 811 est à l'état 0, 320 à l'état 0, 330 à l'état 0, 812 à l'état 0, 310 à l'état 1. Par conséquent, la sortie «down» (conducteur 810) reproduit le signal d'entrée «horloge» véhiculé par le conducteur 670, et la sortie «up» (conducteur 820) est à l'état 1: le compteur 20 décompte.

Si $V = E_H$; 811 est à l'état 0, 320 à l'état 0, 330 à l'état 0, 812 à l'état 1, 310 à l'état 1: la sortie 810 reproduit le signal d'entrée 670, tandis que la sortie 820 est à l'état 1: le compteur 20 décompte.

— Cas de la charge; Vb>V. Alors:

Si $V < E_B$: 811 est à 1, 320 à 1, 330 à l'état 0, 812 à l'état 0, 310 à l'état 0. Par conséquent, la sortie 820 reproduit le signal d'entrée véhiculé par 670, tandis que 810 est à l'état 1: le compteur 20 compte.

Si $E_B < V < E_H$; 811 est à l'état 0, 320 à l'état 1, 330 à l'état 0, 812 à l'état 0, ainsi que 310. D'où 810 est à l'état 1, 820 reproduit l'état du signal véhiculé par 670: le compteur 20 compte.

Si $V = E_H$; 811 est à l'état 0, 320 à l'état 1, 330 à l'état 0, 812 à l'état 1, 310 à l'état 0: D'où 810 et 820 sont à l'état 1: le compteur 20 est bloqué.

— Cas de la non-utilisation du générateur: Vb=V: dans ces conditions, 330 est à l'état 1 et les sorties 810 et 820 sont toutes deux à l'état 1: le compteur 20 est bloqué et maintient la sortie 210 à son état V.

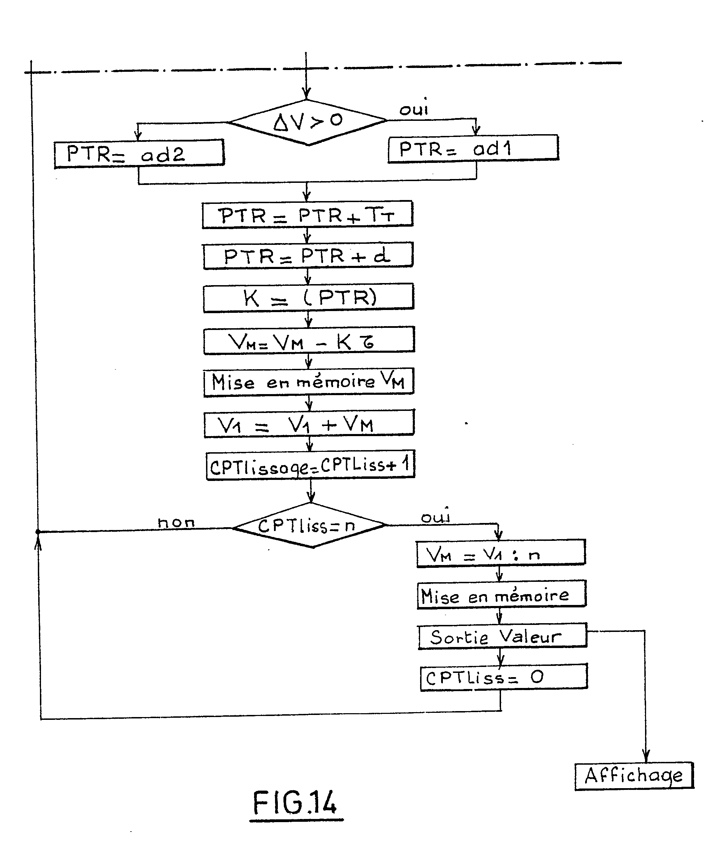

Les fig. 13 et 14 explicitent le procédé de calcul de la force électromotrice suivant l'invention dans le cas où le calculateur utilisé est de type microprogrammé.

Le déroulement débute dès la mise sous tension. Une séquence d'initialisation est tout d'abord exécutée. Dans celle-ci:

— Il y a tout d'abord lancement du convertisseur analogique-numérique de mesure de la tension du générateur G puis stockage de la valeur de la tension à vide dans une mémoire $M_1$; le contenu de $M_1$ est noté $V_M$.

— Le compteur de temps est initialisé à zéro, puis le comptage est lancé.

— Un index définissant le nombre de boucles pendant lesquelles le calcul est effectué avant la sortie d'un résultat est mis à zéro. On note «CPT liss» cet index; une mémoire $M_7$ est mise à zéro.

Il s'ensuit une phase de contrôle:

— Contrôle du branchement du générateur, à l'aide de $V_M$.

— Contrôle de la présence du capteur de température: ce contrôle est effectué par le convertisseur puis par comparaison du résultat avec deux butées, haute et basse.

— Contrôle de l'affichage par test sur la valeur du courant de sortie.

Suivant le résultat de ce contrôle, il y a affichage d'un code d'erreur, puis rebouclage sur le contrôle après temporisation.

Ce qui suit est le lancement des opérations jusqu'à la phase de calcul:

— lancement de la conversion analogique-numérique, lecture de la valeur Vb puis stockage dans une mémoire $M_2$.

— Lecture de la durée écoulée depuis la mise en route du dispositif. Cette valeur $\tau$ est mise dans une mémoire $M_3$.

— Remise à zéro du compteur de temps.

— Nouveau lancement de ce compteur de temps.

Le calcul débute à la phase suivante:

— Calcul de la différence $\Delta V = V_M - Vb$; stockage de $\Delta V$ dans une mémoire $M_4$;

— lancement du convertisseur analogique-numérique;

— lecture de la valeur de la température T sur la deuxième voie; stockage de cette valeur dans une mémoire $M_5$.

— Il s'ensuit un calcul de «tranche de T», qui est un pas d'adressage, qui permettra au pointeur de saisir les bonnes informations situées dans une mémoire R.O.M. $T_T$ est stockée dans une mémoire $M_6$.

La phase suivante est un test sur le signe de $\Delta V$.

— Le résultat de ce test est le positionnement du pointeur sur une certaine adresse définissant le réseau de courbes liées à la charge ou à la décharge du générateur;

— la suite est une incrémentation du pointeur de la valeur «tranche de T», $T_T$, définie ci-dessus.

Ainsi le pointeur est positionné sur une seule courbe.

— Puis le pointeur est incrémenté d'une valeur d qui est fonction de $\Delta V$, ci-dessus calculé.

La valeur d peut être obtenue:

— Soit par positionnement d'un index après comparaison de $\Delta V$ avec des valeurs $\Delta E_i$ mises en mémoire;

— soit par calcul direct quand les lois qui définissent $\Delta V$ sont mises sous formes «analytiques»;

— soit par comparaison et calcul si les courbes sont définies sous forme de réseaux de droites.

Une fois le pointeur positionné sur la bonne adresse, il y a lecture du contenu de la mémoire. Soit K ce contenu.

Le calcul suivant permet d'obtenir la nouvelle valeur de la force électromotrice du générateur par la loi suivante:

$$V_M(t+\tau) = V_M(t) - K\tau$$

$V_M(t)$ étant le contenu de la mémoire $M_1$.

Cette nouvelle valeur est ajoutée au contenu de la mémoire $M_7$, somme des valeurs précédemment calculées, $V_1$. L'index, appelé «CPT liss», est ensuite incrémenté de la valeur 1.

Il s'ensuit une phase de test sur cet index:

— S'il est inférieur à une valeur n, il y a rebouclage sur le contrôle puis lancement d'une nouvelle boucle de calculs.

— S'il est égal à une certaine valeur n, un calcul de moyennage s'ensuit: le contenu de $M_7$, $V_1$ est divisé par n. Le résultat $V_M$ est stocké en $M_1$, puis affiché. L'index de lissage «CPT liss» est mis à zéro. Puis le système reboucle au niveau des contrôles.

Bien entendu, l'invention n'est pas limitée aux deux formes de réalisation décrites ci-dessus. C'est ainsi, par exemple, qu'une version analogique peut être conçue. Une des versions consisterait en la simulation de la courbe de la fig. 2 par un réseau formé d'une diode et d'une résistance. La forme de réalisation de la version microprogrammée n'est pas limitée en elle-même: on peut entrer en mémoire morte soit un ensemble de points pour définir les courbes utilisées, soit entrer une équation numérique. Cette version microprogrammée peut comporter un seul microprocesseur possédant sa propre conversion analogique-numérique, ou un microprocesseur lié à un ensemble de composants externes tels des convertisseurs analogiques-numériques. Cette version microprogrammée peut aussi faire l'objet d'une réalisation par microcalculateur spécifique.

Par ailleurs, dans l'exemple décrit jusqu'à présent, le dispositif fournit une indication de la charge potentiellement disponible dans la batterie à un instant donné, c'est-à-dire la fraction de la charge nominale Qo emmagasinée dans la batterie. Cependant, cette fraction ne sera généralement pas disponible en totalité à l'instant considéré compte tenu du fait que la capacité réelle d'une batterie dépend de son régime de décharge. C'est ainsi, par exemple, qu'une batterie capable de fournir 250 Ah en 5 h ne peut fournir que 210 Ah en 2 h et 180 Ah en 1 h. Or, les mesures montrent qu'une telle batterie aura une charge nominale Qo équivalant à 330 Ah pour une durée de décharge de 20 h. Avec les régimes de décharge précités respectivement de 5 h, 2 h et 1 h, le dispositif indiquera, à la fin de la période considérée, une capacité résiduelle égale respectivement à 24%, 36% et 45% de Qo. En réalité la batterie ne peut alors plus fournir d'énergie au régime de décharge considéré et cette capacité résiduelle ne sera disponible qu'après une certaine période de repos, de l'ordre de plusieurs heures, de la batterie.

On conçoit que l'indication de capacité résiduelle fournie par le dispositif est intéressante pour un utilisateur ayant à se servir de la batterie après une certaine période de repos. Tel est le cas, par exemple, des batteries de véhicules automobiles.

Il n'en va pas de même dans d'autres applications, les chariots de manutention électriques notamment, où un utilisateur a besoin de connaître à tout moment la capacité encore réellement disponible de manière à rejoindre un poste de recharge en temps voulu. Dans ces conditions, il est souhaitable d'adapter l'indication du dispositif au régime de décharge en cours. Pour ce faire, on utilise toujours la même loi de calcul de l'état de charge de la batterie, à savoir:

$$E(t+\tau) = E(t) - f(\Delta V) \cdot \tau,$$

mais avec une fonction $f(\Delta V)$ adaptée au rythme de décharge et définie par

$$f(\Delta V) = \frac{I}{In} \qquad (6)$$

relation dans laquelle:

$$In = \frac{Qn}{3600}$$

— Qn est la capacité disponible de la batterie à un régime de charge ou décharge déterminé.

Comme la relation (4), la relation (6) ne dépend, pour un type de générateur électrochimique donné, que du nombre d'éléments du générateur et de la température, et est indépendante de la charge nominale du générateur. Elle peut être facilement établie expérimentalement et un exemple en est donné à la fig. 1C qui montre la courbe

$$\frac{I}{In} = f(\Delta V)$$

pour une batterie au plomb de 12 V à une température de 20°C.

On notera que la valeur $E(t+\tau)$ calculée à partir de la relation

$$f(\Delta V) = \frac{I}{In}$$

ne représente plus la capacité réelle mais la capacité de la batterie disponible à tout instant. C'est ainsi que, dans l'exemple précité d'une batterie de 250 Ah en 5 h, de 210 Ah en 2 h et de 180 Ah en 1 h, le dispositif affichera une capacité de 0% au bout de 5 h, 2 h et 1 h respectivement.

## Revendications

1. Procédé de mesure de l'état de charge d'un générateur électrochimique pendant la charge ou la décharge de celui-ci, suivant lequel on mesure la tension à vide $V_M$ du générateur lors de son branchement initial, qui représente sa force électromotrice $E(to)$ à l'instant to dudit branchement initial, on mesure ensuite la tension en charge ou en décharge Vb du générateur à un instant $t_1$, on calcule la différence $\Delta V = E(to) - Vb$, et on calcule la valeur de la force électromotrice $E(t_1)$ du générateur représentative de son état de charge à l'instant $t_1$ en fonction de la différence $\Delta V$ et de sa force électromotrice $E(to)$ à l'instant to, caractérisé en ce qu'on calcule $E(t_1)$ conformément à la relation $E(t_1) = E(to) - f(\Delta V) \cdot \tau$ dans laquelle $f(\Delta V)$ est une loi prédéterminée qui, pour un type de générateur donné, est indépendante de la capacité nominale de celui-ci et dépend du nombre d'éléments qui le compose et du signe de la différence $\Delta V$ qui est positif à la décharge et négatif à la charge, et $\tau$ est le temps écoulé entre les instants to et $t_1$.

2. Procédé suivant la revendication 1, caractérisé en ce que ladite loi prédéterminée est de la forme

$$\frac{I}{Io} = f(\Delta V),$$

dans laquelle

— I est le courant sous lequel le générateur est déchargé ou chargé;

$$— Io = \frac{Qo}{3600}$$

— Qo est la charge nominale de la batterie, définie pour une durée de décharge donnée.

3. Procédé suivant la revendication 1, caractérisé en ce que ladite loi prédéterminée est de la forme:

$$\frac{I}{In} = f(\Delta V),$$

dans laquelle:

— I est le courant sous lequel le générateur est déchargé ou chargé;

$$— In = \frac{Qn}{3600}$$

— Qn est la capacité disponible de la batterie à un régime de charge ou de décharge déterminé.

4. Procédé suivant l'une quelconque des revendications 1 à 3, caractérisé en ce qu'on mesure périodiquement la tension Vb du générateur en charge ou décharge et on calcule après chaque mesure sa force électromotrice représentative de son état de charge conformément à la loi $E(t+\tau) = E(t) - f(\Delta V) \cdot \tau$ dans laquelle $E(t+\tau)$ représente la force électromotrice à l'instant $t+\tau$, $E(t)$ représente la force électromotrice à l'instant t calculée précédemment, $\tau$ représente le temps écoulé entre deux mesures successives et $\Delta V = E(t) - Vb$ où Vb est la tension mesurée à l'instant $t+\tau$.

5. Procédé suivant l'une quelconque des revendications 1 à 4, caractérisé en ce qu'on mesure la température T de l'électrolyte du générateur et on détermine la valeur $f(\Delta V)$ en fonction de la variable $\Delta V$ et du paramètre constitué par la température T de l'électrolyte.

6. Dispositif pour la mise en œuvre du procédé suivant l'une quelconque des revendications 1 à 4, caractérisé en ce qu'il comprend des moyens (10) de mesure de la tension (Vb) du générateur (G), des moyens (20) pour mémoriser la tension à vide $(V = E(to))$ du générateur (G) lors de son branchement initial puis la dernière valeur de la force électromotrice calculée $(V, V_M)$, des moyens (40) pour calculer la valeur de la différence $\Delta V$ entre la tension mesurée (Vb) du générateur (G) et la dernière valeur de la force électromotrice calculée $(V, V_M)$, des moyens (30) pour déterminer le signe de ladite différence $\Delta V$, des moyens (70) pour mesurer le temps écoulé $(\tau)$ entre deux mesures successives de la tension du générateur, des moyens (50, 60) pour calculer la variation de force électromotrice $\Delta E = f(\Delta V) \cdot \tau$ du générateur (G), des moyens (80, 20) pour calculer la valeur de la force électromotrice à partir de la dernière valeur calculée $(V, V_M)$ et ladite variation $\Delta E$, et des moyens (90) d'affichage de ladite valeur calculée de la force électromotrice.

7. Dispositif suivant la revendication 6, caractérisé en ce que lesdits moyens de mémorisation (20) comprennent un compteur-décompteur, et lesdits moyens pour calculer la variation de la force électromotrice comprennent un calculateur (50) pour comparer ladite différence $\Delta V$ avec des valeurs $\Delta Vi$ mises en mémoire, un oscillateur local (70) qui produit l'une ou l'autre de deux fréquences prédéterminées suivant le signe de ladite différence, un générateur de fréquence (60) qui produit une fréquence fonction de celle de l'oscillateur local et de la valeur de ladite différence $\Delta V$, et des moyens (80) pour appliquer sélectivement au compteur-décompteur (20) le signal de sortie du générateur de fréquence (60) en fonction du signe de la différence $\Delta V$.

8. Dispositif suivant la revendication 7, caractérisé en ce que les moyens (40) de calcul de la différence $\Delta V$ comprennent un premier ensemble de portes (41) connectées chacune respectivement aux moyens de mesure (10) et aux moyens (30) de détermination du signe de la différence $\Delta V$, un second ensemble de portes (42) connectées chacune respectivement au compteur-décompteur (20) et aux moyens (30) de détermination du signe de la différence $\Delta V$, et un sommateur (43) connecté aux sorties (410, 420) des premier et second ensembles de portes (41, 42).

9. Dispositif suivant la revendication 8, caractérisé en ce que le calculateur (50) pour comparer la différence $\Delta V$ avec des valeurs $\Delta Vi$ mises en mémoire comprend un ensemble de comparateurs (51-59, 61) qui reçoivent chacun à leur entrée la valeur de $\Delta V$ produite à la sortie (430) du sommateur (43) et l'une desdites valeurs $\Delta Vi$ mises en mémoire.

10. Dispositif suivant la revendication 9, caractérisé en ce que le générateur de fréquence (60) comprend un ensemble (610) de portes «ou exclusif» connectées aux sorties desdits comparateurs (51-59, 61) et commandant un ensemble (650) de n interrupteurs analogiques connectés aux sorties respectives Qk (631-641) d'un compteur (630) qui reçoit le signal de l'oscillateur local (70) de fréquence (fo) et le divise par $2^k$, k étant un entier compris entre 2 et $n+1$, ledit ensemble (650) produisant à sa sortie un signal de fréquence $fo/2^k$, la valeur de k dépendant de l'interrupteur analogique sélectionné par ledit ensemble de portes (610).

11. Dispositif suivant la revendication 10, caractérisé en ce que les moyens (80), pour appliquer sélectivement au compteur-décompteur (20) le signal de sortie (670) du générateur de fréquence (60) comprennent un circuit logique combinatoire (800) qui reçoit à ses entrées ledit signal (670) du générateur de fréquence (60), les signaux (310, 320, 330) représentatifs du signe de la différence $\Delta V$, et deux signaux (811, 812) définissant des butées haute et basse permettant de bloquer le compteur-décompteur (20) en cas de dépassement desdites butées par la force électromotrice calculée.

12. Dispositif suivant la revendication 6, caractérisé en ce qu'il comprend des moyens de mesure de la température T de l'électrolyte du générateur, la variation de la force électromotrice étant calculée par lesdits moyens de calcul à partir de la valeur mesurée de la température T et de la valeur et du signe de ladite différence $\Delta V$.

13. Dispositif suivant l'une quelconque des revendications 6 et 12, caractérisé en ce qu'il comprend des moyens pour faire la somme de n valeurs de la force électromotrice calculées consécutivement, et des moyens pour calculer et afficher la moyenne desdites n valeurs.

14. Dispositif suivant l'une quelconque des revendications 6, 12 et 13, caractérisé en ce que lesdits moyens comprennent un calculateur microprogrammé.

## Patentansprüche

1. Verfahren zur Messung des Ladezustandes eines elektrochemischen Stromerzeugers während seines Ladens oder Entladens, bei dem die Leerspannung $(V_M)$ während des erstmaligen Anschliessens des Stromerzeugers gemessen wird, welche die elektromotorische Kraft E (to) zum Zeitpunkt dieses erstmaligen Anschliessens darstellt, danach die Lade- oder Entladespannung Vb des Stromerzeugers zu einem Zeitpunkt $t_1$ gemessen wird, die Differenz $\Delta V = E(to) - Vb$ berechnet wird und der Wert der elektromotorischen Kraft $E(t_1)$ des Stromerzeugers berechnet wird, die dem Ladezustand zum Zeitpunkt $t_1$ entspricht als Funktion der Differenz $\Delta V$ und seiner elektromotorischen Kraft E (to) zum Zeitpunkt to, dadurch gekennzeichnet, dass $E(t_1)$ berechnet wird gemäss

der Beziehung E $(t_1) = E$ (to) $- f$ ($\Delta V$) $\cdot \tau$, in der f ($\Delta V$) ein vorgegebenes Gesetz ist, das, für eine bestimmte Stromerzeugerart, unabhängig von seiner Nennkapazität ist und von der Anzahl Elemente abhängt, aus denen er besteht, sowie vom Vorzeichen der Differenz $\Delta V$, das beim Entladen positiv und beim Laden negativ ist und in der $\tau$ die zwischen den Zeitpunkten to und $t_1$ verstrichene Zeit ist.

2. Verfahren nach Anspruch 1, dadurch gekennzeichnet, dass das genannte vorgegebene Gesetz die Form

$$\frac{I}{Io} = F (\Delta V)$$

aufweist, in der
— I der Strom ist, mit dem der Stromerzeuger entladen oder entladen wird;

$$- \quad Io = \frac{Qo}{3600} \text{ ist;}$$

— Qo die Nennbelastung der Batterie ist, die für eine vorgegebene Entladezeit definiert ist.

3. Verfahren nach Anspruch 1, dadurch gekennzeichnet, dass das genannte vorgegebene Gesetz die Form aufweist:

$$\frac{I}{In} = f (\Delta V), \text{ in der}$$

— I der Strom ist, mit dem der Stromerzeuger entladen oder geladen wird;

$$- \quad In = \frac{Q}{3600} \text{ ist;}$$

— Qn die an der Batterie verfügbare Kapazität ist, während einer bestimmten Stromaufnahme oder Stromabgabe.

4. Verfahren nach einem der Ansprüche 1 bis 3, dadurch gekennzeichnet, dass periodisch die Spannung Vb des Stromerzeugers während des Ladens oder Entladens gemessen wird und dass nach jeder Messung seine elektromotorische Kraft für seinen Ladezustand berechnet wird gemäss der Formel E $(t+\tau) = E$ (t) $- f$ ($\Delta V$) $\cdot \tau$, in der E $(t+\tau)$ die elektromotorische Kraft zum Zeit $t+\tau$ darstellt, E (t) seine vorher berechnete elektromotorische Kraft zum Zeitpunkt t darstellt, $\tau$ die zwischen zwei aufeinanderfolgenden Messungen verstrichene Zeit darstellt und $\Delta V = E$ (t) $- Vb$ ist, wobei Vb die zum Zeitpunkt $t+\tau$ gemessene Spannung ist.

5. Verfahren nach einem der Ansprüche 1 bis 4, dadurch gekennzeichnet, dass die Temperatur T des Elektrolyten des Stromerzeugers gemessen wird und dass der Wert f ($\Delta V$) als Funktion des Variablen $\Delta V$ und des durch die Temperatur T des Elektrolyten dargestellten Parameters bestimmt wird.

6. Vorrichtung zur Durchführung des Verfahrens nach einem der Ansprüche 1 bis 4, dadurch gekennzeichnet, dass es eine Anordnung (10) zur Messung der Spannung (Vb) des Stromerzeugers (G) aufweist, eine Anordnung (20) zur Speicherung der Leerspannung (V = F (to)) des Stromerzeugers (G) während seines erstmaligen Anschliessens und des letzten Wertes der berechneten elektromotorischen Kraft (V, $V_M$), eine Anordnung (40) zur Berechnung des Wertes der Differenz $\Delta V$ zwischen der gemessenen Spannung (Vb) des Stromerzeugers (G) und des letzten berechneten Wertes (V, $V_M$) der elektromotrischen Kraft, eine Anordnung (30) zur Bestimmung des Vorzeichens der genannten Differenz $\Delta V$, eine Anordnung (70) zur Messung der verstrichenen Zeit ($\tau$) zwischen zwei aufeinanderfolgenden Messungen der Spannung des Stromerzeugers, eine Anordnung (50, 60) zur Berechnung der Veränderung der elektromotorischen Kraft $\Delta E = f$ ($\Delta V$) $\cdot \tau$ des Stromerzeugers (G), eine Anordnung (80, 20) zur Berechnung des Wertes der elektromotorischen Kraft ausgehend vom letzten berechneten Wert (V, $V_M$) und der letzten Veränderung $\Delta E$ und eine Anordnung (90) zur Anzeige des genannten berechneten Werts der elektromotorischen Kraft.

7. Vorrichtung nach Anspruch 6, dadurch gekennzeichnet, dass die Speicheranordnung (20) einen Aufwärts-Abwärtszähler aufweist und dass die Anordnung zur Berechnung der Veränderung der elektromotorischen Kraft einen Rechner (50) aufweist, um die Differenz $\Delta V$ mit den gespeicherten Werten $\Delta Vi$ zu vergleichen, sowie einen Oszillator (70), der eine von zwei vorgegebenen Frequenzen entsprechend dem Vorzeichen dieser Differenz erzeugt, einen Frequenzgenerator (60), der eine Frequenz erzeugt als Funktion derjenigen des Oszillators und des Wertes der genannten Differenz $\Delta V$ und eine Anordnung (80) um wahlweise dem Aufwärts-Abwärtszähler (20) das Ausgangssignal des Frequenzgenerators (60) als Funktions des Vorzeichens der Differenz $\Delta V$ zuzuführen.

8. Vorrichtung nach Anspruch 7, dadurch gekennzeichnet, dass die Anordnung (40) zur Berechnung der Differenz $\Delta V$ eine erste Anzahl von Toren (41) aufweist, deren jedes mit entsprechenden Messanordnungen (10) verbunden ist und mit Anordnungen (30) zur Bestimmung des Vorzeichens der Differenz $\Delta V$, eine zweite Anzahl von Toren (42) aufweist, die jeweils entsprechend mit dem Aufwärts-Abwärtszähler (20) und mit einer Anordnung (30) zur Bestimmung des Vorzeichens der Differenz $\Delta V$ verbunden sind, sowie einen Summierer (43), der mit den Ausgängen (410, 420) der ersten und zweiten Anzahl von Toren (41, 42) verbunden ist.

9. Vorrichtung nach Anspruch 8, dadurch gekennzeichnet, dass der Rechner (50) zum Vergleichen der Differenz $\Delta V$ mit den gespeicherten Werten $\Delta Vi$ eine Anzahl von Vergleichern (51-59, 61) aufweist, deren jedem an seinem Eingang den am Ausgang (430) des Summierers (43) erzeugten Wert $\Delta V$ zugeführt wird und einer der gespeicherten Werte $\Delta Vi$.

10. Vorrichtung nach Anspruch 9, dadurch gekennzeichnet, dass der Frequenzgenerator (60) eine Anzahl (610) von Toren «ODER ausschliesslich» aufweist, die mit den Ausgängen der Verglei-

10

cher (51-59, 61) verbunden sind und eine Einheit (650) von n Analogschaltern steuern, die mit den entsprechenden Ausgängen Qk (631-641) eines Vergleichers (630) verbunden sind, der das Signal des Frequenzoszillators (70) empfängt und es durch $2^k$ teilt, wobei k eine ganze Zahl zwischen 2 und n+1 ist, die Einheit (650) an ihrem Ausgang ein Frequenzsignal fo/$2^k$ erzeugt, wobei der Wert k von dem durch die Anzahl der Tore (610) ausgewählten Analogschalter abhängt.

11. Vorrichtung nach Anspruch 10, dadurch gekennzeichnet, dass die Anordnung (80) zum wahlweisen Anlegen des Ausgangssignals (670) des Frequenzgenerators (60) an dem Aufwärtszähler-Abwärtszähler (20) einen stufenförmigen logischen Schaltkreis (800) aufweist, dessen Eingängen das Signal (670) des Frequenzgenerators (60), die das Vorzeichen der Differenz ΔV darstellenden Signale (310, 320, 330) und zwei Signale (811, 812) zugeführt werden, die die oberen und unteren Schwellen darstellen, die ein Blockieren des Aufwartszählers-Abwärtszählers (20) ermöglichen, sofern diese Schwellwerte von der berechneten elektromotorischen Kraft überschritten werden.

12. Vorrichtung nach Anspruch 6, dadurch gekennzeichnet, dass sie eine Messanordnung für die Temperatur T des Elektrolyten des Stromerzeugers aufweist, dass die Veränderung der elektromotorischen Kraft von der Rechenanordnung berechnet wird ausgehend vom gemessenen Wert der Temperatur T und des Wertes des Vorzeichens der Differenz ΔV.

13. Vorrichtung nach einem der Ansprüche 6 und 12, dadurch gekennzeichnet, dass sie eine Anordnung aufweist, um die Summe aus den n Werten der aufeinanderfolgend berechneten elektromotorischen Kraft zu bilden und eine Anordnung zum Berechnen und Anzeigen des Mittelwertes der n Werte.

14. Vorrichtung nach einem der Ansprüche 6, 12 und 13, dadurch gekennzeichnet, dass diese Anordnung einen Rechner mit Mikroprogramm aufweist.

## Claims

1. A process for measuring the state of charge of an electrochemical generator during charging or discharging thereof, comprising measuring the no-load voltage $V_M$ of the generator upon initial connection thereof, which represents its electromotive force E (to) at the time to of initial connection, then measuring the charging or discharging voltage Vb of the generator at a time $t_1$, calculating the difference $\Delta V = E$ (to) $- Vb$ and calculating the value of the electromotive force E ($t_1$) of the generator which is representative of its state of charge at the time $t_1$ in dependence on the difference ΔV and its electromotive force E (to) at the time to, characterised by calculating E ($t_1$) in accordance with the relationship E ($t_1$) = E (to) $-f$ (ΔV)·τ wherein f (ΔV) is a predetermined law which, for a given type of generator, is independent of the nominal capacity thereof and depends on the number of components which make up the generator and the sign of the difference ΔV which is positive on discharging and negative on charging, and τ is the period of time which elapses between the times to and $t_1$.

2. A process according to claim 1 characterised in that said predetermined law is of the form

$$\frac{I}{Io} = f (\Delta V)$$

wherein
— I is the current at which the generator is discharged or charged;

$$- \quad Io = \frac{Qo}{3600}$$

— Qo is the nominal charge of the battery, defined for a given discharge period.

3. A process according to claim 1 characterised in that said predetermined law is of the form

$$\frac{I}{In} = f (\Delta V)$$

wherein:
— I is the current at which the generator is discharged or charged;

$$- \quad In = \frac{Qn}{3600}$$

— Qn is the available capacity of the battery for a given charge or discharge mode.

4. A process according to any one of claims 1 to 3, characterised by periodically measuring the voltage Vb of the generator in the charging or discharging mode and calculating after each measurement operation its electromotive force which is representative of its state of charge in accordance with the law E (t+τ) = E (t) $-f$ (ΔV)·τ, wherein E (t+τ) represents the electromotive force at the time t+τ, E (t) represents the electromotive force at the previously calculated time t, τ represents the period of time which elapses between two successive measurements and ΔV = E (t) $-Vb$, wherein Vb is the voltage measured at the time t+τ.

5. A process according to any one of claims 1 to 4 characterised by measuring the temperature T of the electrolyte of the generator and determining the value f (ΔV) in dependence on the variable ΔV and the parameter formed by the temperature T of the electrolyte.

6. Apparatus for carrying out the process according to any one of claims 1 to 4 characterised in that it comprises means (10) for measuring the voltage (Vb) of the generator (G), means (20) for memorising the no-load voltage (V=F (to)) of the generator (G) upon initial connection thereof and then the last value of the calculated electromotive force (V, Vm), means (40) for calculating the value of the difference ΔV between the measured voltage (Vb) of the generator (G) and the last value of the calculated electromotive force (V, $V_M$), means (30) for determining the sign of said difference $\Delta V$, means (70) for measuring the period of time ($\tau$) between two successive measurements in respect of the voltage of the generator, means (50, 60) for calculating the variation in electromotive force $\Delta E = f(\Delta V) \cdot \tau$ of the generator (G), means (80, 20) for calculating the value of the electromotive force from the last calculated value (V, $V_M$) and said variation $\Delta E$, and means (90) for displaying said calculated value of the electromotive force.

7. Apparatus according to claim 6 characterised in that said memory means (20) comprise an up-down counter and said means for calculating the variation in the electromotive force comprise a computing means (50) for comparing said difference $\Delta V$ to values $\Delta Vi$ which are put into the memory, a local oscillator (70) which produces one or other of two predetermined frequencies in accordance with the sign of said difference, a frequency generator (60) which produces a frequency which is dependent on that of the local oscillator and the value of said difference $\Delta V$, and means (80) for selectively applying to said up-down counter (20) the output signal of the frequency generator (60) in dependence on the sign of the difference $\Delta V$.

8. Apparatus according to claim 7 characterised in that the means (40) for calculating the difference $\Delta V$ comprise a first assembly of gates (41) which are each respectively connected to the measuring means (10) and to the means (30) for determining the sign of the difference $\Delta V$, a second assembly of gates (42) which are each respectively connected to the up-down counter (20) and to the means (30) for determining the sign of the difference $\Delta V$, and a summing means (43) connected to the outputs (410, 420) of the first and second assemblies of gates (41, 42).

9. Apparatus according to claim 8 characterised in that the computing means (50) for comparing the difference $\Delta V$ to values $\Delta Vi$ which are put into the memory comprises an assembly of comparators (51-59, 61) which each receive at their input the value of $\Delta V$ produced at the output (430) of the summing means (43) and one of said values $\Delta Vi$ which are put into the memory.

10. Apparatus according to claim 9, characterised in that the frequency generator (60) comprises an assembly (610) of or-exclusive gates which are connected to the outputs of said comparators (51-59, 61) and control an assembly (650) of n analog switches connected to the respective outputs Qk (631-641) of a counter (630) which receives the signal from the local oscillator (70) at a frequency (fo) and divides it by $2^k$, k being an integer of between 2 and n+1, said assembly (650) producing at its output a signal at a frequency $fo/2^k$, the value of k depending on the analog switch selected by said assembly of gates (610).

11. Apparatus according to claim 10, characterised in that the means (80) for selectively applying the output signal (670) of the frequency generator (60) to the up-down counter (20) comprise a combinational logic circuit (800) which receives at its inputs said signal (670) from the frequency generator (60), the signals (310, 320, 330) representative of the sign of the difference $\Delta V$, and two signals (811, 812) defining high and low stops for blocking the up-down counter (20) in the event of the calculated electromotive force going beyond said stops.

12. Apparatus according to claim 6, characterised in that it comprises means for measuring the temperature T of the electrolyte of the generator, the variation in the electromotive force being calculated by said calculating means from the measured value of the temperature T and the value and the sign of said difference $\Delta V$.

13. Apparatus according to either one of claims 6 and 12, characterised in that it comprises means for producing the sum of n consecutively calculated values of the electromotive force and means for calculating and displaying the average of said n values.

14. Apparatus according to any one of claims 6, 12 and 13, characterised in that said means comprise a microprogrammed computer.

FIG.1A

FIG.1B

FIG.1C

FIG.2

FIG.3

FIG.6

FIG.7

0 090 699 0

FIG.4

FIG.5

FIG.10

FIG.11

FIG.8

FIG.9

0 090 699

## FIG.12

811
320
670
330
812
310
810
820
800

Debut

Initialisation

Batt-Suff → non → code erreur 1

oui

capteur de T présent → non → code erreur 2

oui

Affichage commande → code erreur 3

oui

Lancement du C.A.N

Temporisation

Lecture de Vb

Lecture de $\tau$

R.A.Z de $\tau$

Lancement de la Tempo

Calcul de $\Delta v = V_M - V b$

Lancement du C.A.N

Lecture de T

Calcul de $T_T$

## FIG.13

25

**FIG.14**